# FASCICULE DE BREVET EUROPEEN

(11) **EP 3 776 630 B1**
(45) Date de publication et mention de la délivrance du brevet: **04.09.2024**
(21) Numéro de dépôt: 19721698.9
(22) Date de dépôt: 27.03.2019
(51) Int. Cl.: H10N 30/073

(54) **PROCÉDÉ DE FABRICATION D'UN SUBSTRAT POUR FILTRE RADIOFRÉQUENCE**
VERFAHREN ZUR HERSTELLUNG EINES SUBSTRATS FÜR EINEN HOCHFREQUENZFILTER
METHOD FOR MANUFACTURING A SUBSTRATE FOR A RADIOFREQUENCY FILTER

(30) Priorité: 29.03.2018 FR 1800258
(43) Date de publication de la demande: 17.02.2021
(73) Titulaire: SOITEC, 38190 Bernin (FR)
(72) Inventeur: BELHACHEMI, Djamel, 38400 Saint Martin D'Hères (FR); BARGE, Thierry, 38160 Chevrieres (FR)
(74) Mandataire: IP Trust
(86) Numéro de dépôt international: PCT/IB2019/000204
(87) Numéro de publication internationale: WO 2019/186265

(56) Documents cités:
- JP-A- 2013 179 405
- US-A1- 2002 048 728
- US-A1- 2014 167 565

## Description

### DOMAINE DE L'INVENTION

La présente invention concerne un procédé de fabrication d'un substrat pour filtre radiofréquence.

### ETAT DE LA TECHNIQUE

Il est connu de fabriquer un dispositif radiofréquence (RF), tel qu'un résonateur ou filtre, sur un substrat comprenant successivement, de sa base vers sa surface, un substrat support, généralement en un matériau semi-conducteur tel que du silicium, une couche électriquement isolante et une couche piézoélectrique.

US 2002/048728, JP 2013 179405 et US 2014/167565 décrivent la fabrication de substrats en matériau semi-conducteur .

Les matériaux piézoélectriques usuellement utilisés tels que le niobate de lithium ou le tantalate de lithium ont des coefficients d'expansion thermique assez élevés et anisotropes ce qui rend l'assemblage sur des substrats support tels que le silicium difficile. Des problèmes de casse ou de détachement lors de recuit thermique lors des étapes de processing ou encore de packaging ou encore lors d'étapes de découpages peuvent engendrer l'inadaptation de tels substrats assemblés.

En plus les filtres à ondes acoustiques de surface (SAW, acronyme du terme anglo-saxon « Surface Acoustic Wave ») comprennent typiquement une couche piézoélectrique épaisse (c'est-à-dire d'épaisseur généralement de plusieurs dizaines de µm) et deux électrodes sous la forme de deux peignes métalliques interdigités déposés sur la surface de ladite couche piézoélectrique. Un signal électrique, typiquement une variation de tension électrique, appliqué à une électrode est converti en onde élastique qui se propage à la surface de la couche piézoélectrique. La propagation de cette onde élastique est favorisée si la fréquence de l'onde correspond à la bande de fréquence du filtre. Cette onde est à nouveau convertie en signal électrique en parvenant à l'autre électrode.

Cependant, il existe des modes parasites de propagation de l'onde qui s'étendent dans l'épaisseur de la couche piézoélectrique et sont susceptibles de se refléter à l'interface avec le substrat support sous-jacent. Ce phénomène est appelé « rattle » en anglais.

Pour éviter ces modes parasites, il est connu de faire en sorte que la surface de la couche piézoélectrique située à l'interface avec la couche électriquement isolante soit suffisamment rugueuse pour permettre une réflexion des ondes parasites dans toutes les directions (effet dispersion) et éviter leur transmission dans le substrat.

Compte tenu de la longueur d'onde considérée, la rugosité de la surface de la couche piézoélectrique est très élevée, de l'ordre de quelques µm.

La fabrication du substrat implique de coller la surface rugueuse de la couche piézoélectrique, éventuellement recouverte de la couche électriquement isolante, sur le substrat support.

Cependant, pour assurer une bonne adhésion entre la couche piézoélectrique et le substrat support en dépit d'une telle rugosité, le procédé actuel nécessite un grand nombre d'étapes successives, qui le rendent long et coûteux.

### EXPOSE DE L'INVENTION

La présente invention vise à pallier ces limitations de l'état de la technique en proposant un procédé de fabrication d'un substrat pour filtre radiofréquence. Par ceci il est possible de remédier aux problèmes actuellement rencontrés.

L'invention concerne un procédé de fabrication d'un substrat pour filtre radiofréquence par assemblage d'une couche piézoélectrique sur un substrat support par l'intermédiaire d'une couche électriquement isolante caractérisé en ce qu'il comprend les étapes de dépôt de la couche électriquement isolante par enduction centrifuge d'un oxyde appartenant à la famille des SOG (Spin On Glass) sur la surface de la couche piézoélectrique à assembler sur le substrat support suivi d'un recuit pour densifier ladite couche électriquement isolante avant assemblage.

Dans des modes de réalisation avantageux l'épaisseur de la couche piézoélectrique est supérieure à 5 µm, préférentiellement supérieure à 10 µm.

Dans des modes de réalisation avantageux la surface de la couche piézoélectrique à assembler sur le substrat support présente une surface rugueuse adaptée pour réfléchir une onde radiofréquence.

Dans des modes de réalisation avantageux la surface rugueuse de la couche piézoélectrique présente une rugosité supérieure à 1 µm, préférentiellement supérieure à 3 µm.

Dans des modes de réalisation avantageux le substrat support est de matériau silicium.

Dans des modes de réalisation avantageux le substrat support de matériau silicium comprend une couche de piégeage vers l'interface à assembler avec la couche piézoélectrique.

Dans des modes de réalisation avantageux la couche piézoélectrique (200, 200') est de niobate de lithium ou tantalate de lithium.

### DESCRIPTION DES FIGURES

D'autres caractéristiques et avantages de l'invention seront mieux compris à la lecture de la description détaillée qui va suivre, en référence aux dessins annexés sur lesquels :
- La figure 1 illustre un procédé de fabrication d'un substrat pour filtre radiofréquence selon un mode de réalisation de l'invention;
- La figure 2 illustre un procédé de fabrication d'un substrat pour filtre radiofréquence selon un mode de réalisation de l'invention ;

Pour favoriser la lisibilité des figures, les différentes couches ne sont pas nécessairement représentées à l'échelle.

### DESCRIPTION DETAILLEE DE MODES DE REALISATION DE L'INVENTION

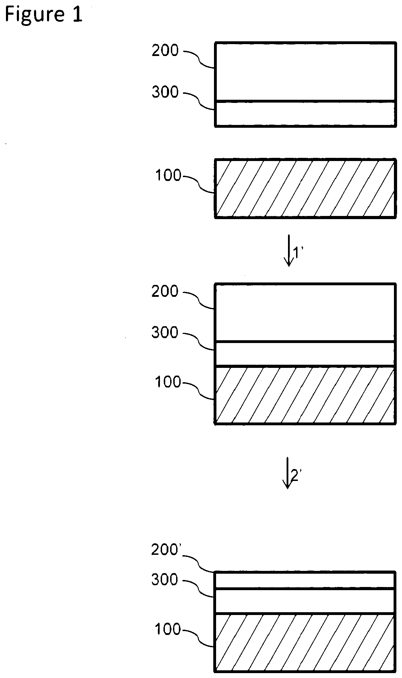

La figure 1 illustre schématiquement le procédé de fabrication d'un substrat pour filtre radiofréquence selon un mode de réalisation de la présente invention. La figure 1 illustre un substrat support 100 sur lequel on assemble une couche piézoélectrique 200 via l'intermédiaire d'une couche électriquement isolante 300.

La couche électriquement isolante est généralement choisi parmi la famille des SOG (du terme anglo-saxon « Spin On Glass » signifiant verre déposable par centrifugation) qui ont la propriété d'être à l'état liquide à température ambiante mais peuvent se densifier, et être rendus solides, grâce à un traitement thermique approprié.

Cette technique consiste à faire tourner le substrat sur lequel est prévu le dépôt de la couche électriquement isolante 300 sur lui-même à une vitesse sensiblement constante et relativement élevée, afin d'étaler ladite couche en état liquide de façon uniforme sur l'ensemble de la surface du substrat par force centrifuge. A cet effet, le substrat est typiquement posé et maintenu par tirage du vide sur un plateau tournant.

L'homme du métier est en mesure de déterminer les conditions opératoires, telles que le volume déposé sur la surface du substrat, la vitesse de rotation du substrat, et la durée minimale du dépôt en fonction de l'épaisseur souhaitée pour la couche adhésive.

L'épaisseur de la couche électriquement isolante 300 est typiquement comprise entre 2 µm et 8 µm. En plus la technique d'enduction centrifuge utilisée est avantageuse en ce que le dépôt de la couche 300 est effectué à température ambiante, et est suivi d'un recuit de densification à une température d'environ 250°C, et n'engendre donc pas de déformation du substrat sur lequel la couche diélectrique est formée.

Une couche électriquement isolante 300 d'oxyde de type SOG permet de maintenir les performances acoustiques d'un dispositif radiofréquence obtenu ultérieurement à partir du substrat piézoélectrique à un niveau optimal.

Selon un exemple non-limitatif, la couche électriquement isolante 300 peut être choisie parmi des familles des SOG de types « silicates » ou encore « methylsilsesquioxane , commercialisées par exemple sous les références « 20B » ou « 400F » par la société FILMTRONICS ou « FOX16 » par la société DOW CORNING.

La couche piézoélectrique 200 sur laquelle a été déposée et densifié la couche électriquement isolante 300 est assemblé sur le substrat support 100 préférentiellement via un collage direct par adhésion moléculaire. Le collage est de préférence réalisé à température ambiante, soit environ 20°C. Il est cependant possible de réaliser le collage à chaud à une température comprise entre 20°C et 50°C, et de manière davantage préférée entre 20°C et 30°C.

De plus, l'étape de collage est avantageusement effectuée à basse pression, c'est-à-dire à une pression inférieure ou égale à 5 mTorr, ce qui permet de désorber l'eau des surfaces formant l'interface de collage, c'est-à-dire la surface de la couche électriquement isolante 300 et la surface du substrat support 100. Réaliser l'étape de collage sous vide permet d'améliorer encore davantage la désorption de l'eau à l'interface de collage.

Un traitement thermique afin de renforcer l'interface de collage peut se faire à des températures basses allant jusqu'à 300°C sans que l'ensemble de l'assemblage subit des déformations trop importantes engendrant la casse des matériaux ou encore le détachement au niveau de l'interface de collage.

L'énergie de collage obtenu par le collage direct entre la surface du substrat support 100 et la couche électriquement isolante 300 de la présente invention est élevée et permet non seulement l'étape d'amincissement de la couche piézoélectrique par gravure mécano-chimique (CMP) mais aussi le découpage finale de plaque assemblée afin d'obtenir des dispositifs radiofréquences et ceci malgré une différence importante en coéfficient d'expansion thermique des matériaux piézoélectriques de la couche piézoélectrique 200 utilisée ainsi que du matériau du substrat support 100 utilisé.

Selon un exemple non-limitatif de l'invention, le substrat support 100 peut être de matériau silicium.

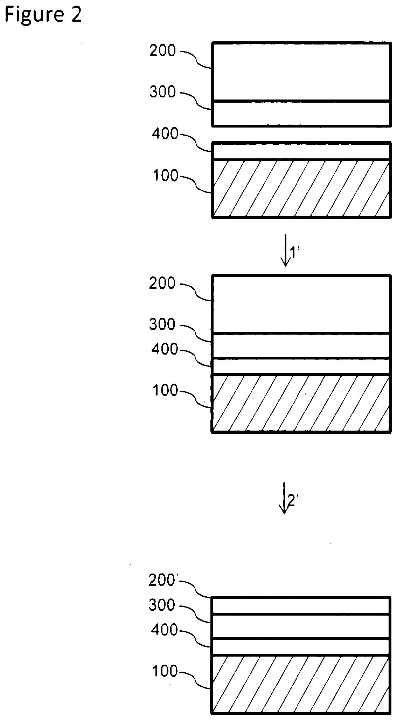

Selon un autre mode de réalisation non-limitatif, illustré schématiquement en figure 2, le substrat support 100 peut être de matériau silicium comprenant en autre une couche de piégeage 400 vers l'interface à assembler avec la couche électriquement isolante 300, permettant le piégeage de porteurs électriques induite par le fonctionnement en fréquence du dispositif radiofréquence. Cette couche permet ainsi de réduire les pertes d'insertion et améliorer les performances desdites dispositifs.

Selon un exemple non-limitatif de l'invention le matériau piézoélectrique peut être choisi parmi le niobate de lithium et le tantalate de lithium.

L'épaisseur prédéterminée de la couche piézoélectrique 200 est de préférence supérieure à 5 µm, ou encore plus préférentiellement supérieure à 10 µm.

Etant donné la différence importante de coefficient thermique d'expansion une telle épaisseur élevée engendre des contraintes difficilement supportables subies par l'assemblage de la couche piézoélectrique 200 sur le substrat support 100. L'assemblage selon la présente invention permet d'obtenir des énergies de collage permettant de maintenir mécaniquement intacte le substrat qui pourra ainsi subir des étapes de procédé tels que des étapes d'amincissement, des étapes de dépôt d'électrodes impliquant des températures allant jusqu'à 300°C, ou encore des étapes de découpages afin d'isoler les dispositifs radiofréquence obtenue sur ce substrat assemblé.

Selon un exemple non-limitatif de l'invention la surface de la couche piézoélectrique 200 à assembler sur le substrat support présente une surface rugueuse adaptée pour réfléchir une onde radiofréquence. Ceci permet de réduire l'impact d'ondes parasites réfléchies à des interfaces quelconques présentes au sein d'un substrat hybride d'une couche piézoélectrique assemblée à un support. Dans des modes de réalisation avantageux la surface rugueuse de la couche piézoélectrique présente une rugosité supérieure à 1 µm, préférentiellement supérieure à 3 µm, correspondant sensiblement à la longueur des ondes parasites. Ces ondes parasites apparaissent par ailleurs surtout pour des structure piézoélectriques d'une épaisseur supérieur à 5 µm, voir 10 µm, pour lesquels l'assemblage de la présente invention présente des avantages. Il est à noter que la technique d'enduction centrifuge a un effet lissant et des épaisseurs envisagés de la couche électriquement isolante 300 comprise entre 2 µm à 8 µm permettent non seulement d'obtenir un assemblage ayant une bonne énergie de collage mais aussi en même d'éviter des étapes supplémentaires de planarisation et lissage si ce dépôt d'enduction centrifuge s'applique à une surface rugueuse telle que décrite auparavant.

## Revendications

1. Procédé de fabrication d'un substrat pour filtre radiofréquence à ondes acoustiques de surface par assemblage d'une couche piézoélectrique (200, 200') sur un substrat support (100) par l'intermédiaire d'une couche électriquement isolante (300) **caractérisé en ce qu'**il comprend les étapes de dépôt de la couche électriquement isolante (300) par enduction centrifuge d'un oxyde appartenant à la famille des SOG (Spin On Glass) sur la surface de la couche piézoélectrique (200, 200') à assembler sur le substrat support (100) suivi d'un recuit pour densifier ladite couche électriquement isolante avant assemblage, ledit assemblage entre la couche électriquement isolante et la surface du substrat support étant opéré par un collage direct par adhésion moléculaire.

2. Procédé selon la revendication précédente dans lequel l'épaisseur de la couche piézoélectrique (200, 200') est supérieure à 5 um, préférentiellement supérieure à 10 µm.

3. Procédé selon une des revendications précédentes dans lequel la surface de la couche piézoélectrique (200, 200') à assembler sur le substrat support (100) présente une surface rugueuse adaptée pour réfléchir une onde radiofréquence.

4. Procédé selon la revendication précédente dans lequel la surface rugueuse de la couche piézoélectrique (200, 200') présente une rugosité supérieure à 1 µm, préférentiellement supérieure à 3 µm.

5. Procédé selon une des revendications précédentes dans lequel le substrat support (100) est de matériau silicium.

6. Procédé selon la revendication précédente dans lequel le substrat support (100) de matériau silicium comprend une couche de piégeage (400) vers l'interface à assembler avec la couche piézoélectrique (200, 200').

7. Procédé selon une des revendications précédentes dans lequel la couche piézoélectrique (200, 200') est de niobate de lithium ou tantalate de lithium.

## Patentansprüche

1. Verfahren zum Herstellen eines Substrats für ein Oberflächenwellenhochfrequenzfilter durch Montieren einer piezoelektrischen Schicht (200, 200') an einem Trägersubstrat (100) über eine elektrisch isolierende Schicht (300), **dadurch gekennzeichnet, dass** es die Schritte eines Aufbringens der elektrisch isolierenden Schicht (300) durch Schleuderbeschichten eines Oxids, das zu der SOG-Familie (Spin On Glass) gehört, auf die Oberfläche der piezoelektrischen Schicht (200, 200'), die auf dem Trägersubstrat (100) zu montieren ist, gefolgt von einem Glühen zum Verdichten der elektrisch isolierenden Schicht vor der Montage umfasst, wobei die Montage zwischen der elektrisch isolierenden Schicht und der Oberfläche des Trägersubstrats durch ein direktes Blocken durch molekulare Adhäsion erfolgt.

2. Verfahren nach dem vorstehenden Anspruch, wobei die Dicke der piezoelektrischen Schicht (200, 200') größer als 5 µm, vorzugsweise größer als 10 µm, ist.

3. Verfahren nach einem der vorstehenden Ansprüche, wobei die Oberfläche der auf dem Trägersubstrat (100) zu montierenden piezoelektrischen Schicht (200, 200') eine raue Oberfläche aufweist, die angepasst ist, um eine Funkfrequenzwelle zu reflektieren.

4. Verfahren nach dem vorstehenden Anspruch, wobei die raue Oberfläche der piezoelektrischen Schicht (200, 200') eine Rauhigkeit von größer als 1 µm, vorzugsweise größer als 3 µm, aufweist.

5. Verfahren nach einem der vorstehenden Ansprüche, wobei das Trägersubstrat (100) aus Silicium-Material besteht.

6. Verfahren nach dem vorstehenden Anspruch, wobei das Trägersubstrat (100) aus Silicium-Material eine Einfangschicht (400) in Richtung der mit der piezoelektrischen Schicht (200, 200') zu montierenden Grenzfläche umfasst.

7. Verfahren nach einem der vorstehenden Ansprüche, wobei die piezoelektrische Schicht (200, 200') aus Lithiumniobat oder aus Lithiumtantalat besteht.

## Claims

1. Method for manufacturing a substrate for a surface acoustic wave radio frequency filter by assembling a piezoelectric layer (200, 200') on a support substrate (100) via an electrically insulating layer (300), **characterized in that** it comprises the steps of depositing the electrically insulating layer (300) by means of spin coating an oxide belonging to the SOG (Spin On Glass) family on the surface of the piezoelectric layer (200, 200') to be assembled on the support substrate (100), followed by annealing to densify said electrically insulating layer prior to assembly, said assembly between the electrically insulating layer and the support substrate surface being effected by direct molecular adhesion bonding.

2. Method according to the preceding claim, wherein the thickness of the piezoelectric layer (200, 200') is greater than 5 µm, preferably greater than 10 µm.

3. Method according to one of the preceding claims, wherein the surface of the piezoelectric layer (200, 200') to be assembled on the support substrate (100) has a rough surface suitable for reflecting a radio-frequency wave.

4. Method according to the preceding claim, wherein the rough surface of the piezoelectric layer (200, 200') has a roughness greater than 1 µm, preferably greater than 3 µm.

5. Method according to one of the preceding claims, wherein the support substrate (100) is made of silicon material.

6. Method according to the preceding claim, wherein the support substrate (100) made of silicon material comprises a trapping layer (400) toward the interface to be assembled with the piezoelectric layer (200, 200').

7. Method according to one of the preceding claims, wherein the piezoelectric layer (200, 200') is made of lithium niobate or lithium tantalate.
